# EUROPEAN PATENT APPLICATION

(11) **EP 4 709 073 A1**
(43) Date of publication of application: **11.03.2026**
(21) Application number: 24933733.8
(22) Date of filing: 20.09.2024
(51) Int. Cl.: H10B 12/00

(54) **SEMICONDUCTOR STRUCTURE, SEMICONDUCTOR DEVICE, AND METHOD FOR PREPARING SEMICONDUCTOR STRUCTURE**

(30) Priority: 01.04.2024 CN 202410389625
(71) Applicant: CXMT Corporation, Hefei City, Anhui Province 230601 (CN)
(72) Inventor: WU, Baorun, Hefei, Anhui 230601 (CN); LIU, Zhongming, Hefei, Anhui 230601 (CN); YANG, Xiaodong, Hefei, Anhui 230601 (CN)
(74) Representative: Gulde & Partner
(86) International application number: PCT/CN2024/119984
(87) International publication number: WO 2025/208806

(57) **Abstract**

The present disclosure provides a semiconductor structure, a semiconductor device, and a method for manufacturing the semiconductor structure, and relates to the technical field of semiconductors. The semiconductor structure includes: a substrate, where a plurality of active pillars spaced apart from each other along a first direction and a second direction are formed in the substrate, the plurality of active pillars extend along a third direction, the first direction intersects with the second direction, and both the first direction and the second direction are perpendicular to the third direction; and capacitor contact structures, where the capacitor contact structures cover top surfaces of the plurality of active pillars for connection to capacitor structures, top surfaces of the capacitor contact structures are non-planar, and projected areas of the capacitor contact structures on planes perpendicular to the third direction are larger than projected areas of the plurality of active pillars on planes perpendicular to the third direction.

## Description

### CROSS-REFERENCE TO RELATED APPLICATIONS

The present application is presented based on and claims priority to Chinese Patent Application No. 202410389625.5 filed on April 1, 2024, which is incorporated herein by reference in its entirety.

### TECHNICAL FIELD

The present disclosure relates to the technical field of semiconductors, in particular to a semiconductor structure, a semiconductor device, and a method for manufacturing the semiconductor structure.

### BACKGROUND

A dynamic random access memory (DRAM) is a volatile memory, and is composed of a plurality of memory cells. Each of the plurality of memory cells mainly includes a transistor and a capacitor structure, and the plurality of memory cells are electrically connected to each other through word lines (WLs) and bit lines (BLs). With the development of semiconductor technologies, an architecture scheme of changing a horizontal transistor to a vertical channel transistor has been proposed. In the DRAM, active pillars extending vertically are formed on a substrate, surrounding gates are formed outside the active pillars, and buried bit lines and buried word lines are formed.

However, the DRAM with the vertical channel transistors still faces many problems, such as the electrical problem, which has become an urgent technical problem to be solved.

It should be noted that the information disclosed in the above background section is only used for enhancement of understanding of the background of the present disclosure and therefore may include information that does not constitute the prior art known to those of ordinary skill in the art.

### SUMMARY

The present disclosure provides a semiconductor structure, a semiconductor device, and a method for manufacturing the semiconductor structure. The semiconductor structure can reduce contact resistance between a capacitor structure and an active pillar, thereby improving the transmission rate of a DRAM.

Additional features and advantages of the present disclosure will become apparent from the detailed description below, or will be learned in part by practice of the present disclosure.

According to an aspect of the present disclosure, a semiconductor structure is provided. The semiconductor structure includes: a substrate, where a plurality of active pillars spaced apart from each other along a first direction and a second direction are formed in the substrate, the plurality of active pillars extend along a third direction, the first direction intersects with the second direction, and both the first direction and the second direction are perpendicular to the third direction; and
capacitor contact structures, where the capacitor contact structures cover top surfaces of the plurality of active pillars for connection to capacitor structures, and
where top surfaces of the capacitor contact structures are non-planar, and projected areas of the capacitor contact structures on planes perpendicular to the third direction are larger than projected areas of the plurality of active pillars on planes perpendicular to the third direction.

In one embodiment, the top surfaces of the capacitor contact structures are arc-shaped surfaces, and first contact surfaces between the plurality of active pillars and the capacitor contact structures are arc-shaped surfaces protruding toward the capacitor contact structures.

In one embodiment, center lines of the plurality of active pillars substantially overlap with center lines of the capacitor contact structures.

In one embodiment, first isolation structures are formed between adjacent ones of the plurality of active pillars along the first direction, and first voids are present in the first isolation structures.

In one embodiment, at least portions of the first contact surfaces between the plurality of active pillars and the capacitor contact structures are higher than top surfaces of the first isolation structures.

In one embodiment, gate structures are further formed in the substrate, the gate structures surround portions of the plurality of active pillars, adjacent ones of the gate structures along the second direction are in contact connection to each other, adjacent ones of the gate structures along the first direction are insulated from each other;
bit line structures are further formed in the substrate, the bit line structures are located on a side of the substrate away from an extension direction of the plurality of active pillars, the bit line structures extend along the first direction, and adjacent ones of the bit line structures along the second direction are insulated from each other.

In one embodiment, the semiconductor structure further includes: an insulating layer, where the insulating layer covers the top surfaces of the first isolation structures, and both adjacent ones of the capacitor contact structures along the first direction and adjacent ones of the capacitor contact structures along the second direction are isolated by the insulating layer; and
the capacitor structures located on the capacitor contact structures, where second contact surfaces between the capacitor structures and the capacitor contact structures are arc-shaped surfaces.

According to another aspect of the present disclosure, a semiconductor device is provided. The semiconductor device is obtained by bonding the above semiconductor structure to a target wafer.

According to yet another aspect of the present disclosure, a method for manufacturing the above semiconductor structure is provided. The method includes:
providing a substrate, and forming a plurality of initial active pillars spaced apart from each other along a first direction and a second direction in the substrate, where the plurality of initial active pillars extend along a third direction, the first direction intersects with the second direction, and both the first direction and the second direction are perpendicular to the third direction;
generating epitaxial structures on top surfaces of the plurality of initial active pillars through epitaxial growth;
depositing a metal layer to cover the epitaxial structures; and
performing a thermal annealing step to obtain capacitor contact structures through reaction, such that unreacted portions of the plurality of initial active pillars and the epitaxial structures serve as active pillars of the semiconductor structure,
where top surfaces of the capacitor contact structures are non-planar, and projected areas of the capacitor contact structures on planes perpendicular to the third direction are larger than projected areas of the active pillars on planes perpendicular to the third direction.

In one embodiment, top surfaces of the epitaxial structures are non-planar, and projected areas of the epitaxial structures on planes perpendicular to the third direction are larger than projected areas of the plurality of initial active pillars on planes perpendicular to the third direction.

In one embodiment, the top surfaces of the capacitor contact structures and the top surfaces of the epitaxial structures are arc-shaped surfaces, and first contact surfaces between the active pillars and the capacitor contact structures are arc-shaped surfaces protruding toward the capacitor contact structures.

In one embodiment, the manufacturing method further includes: forming first isolation structures between adjacent ones of the active pillars along the first direction and forming first voids in the first isolation structures.

In one embodiment, bottom surfaces of the epitaxial structures are flush with top surfaces of the first isolation structures, and at least portions of first contact surfaces between the active pillars and the capacitor contact structures are higher than the top surfaces of the first isolation structures.

In one embodiment, the manufacturing method further includes: removing unreacted portions of the metal layer after the thermal annealing step is performed. In one embodiment, the metal layer is made of Co or Ti, and the epitaxial structures are made of monocrystalline silicon.

It should be understood that both the foregoing general description and the following detailed description are exemplary and explanatory only and are not restrictive of the present disclosure.

### BRIEF DESCRIPTION OF THE DRAWINGS

The accompanying drawings, which are incorporated in and constitute a part of the specification, illustrate embodiments consistent with the present disclosure and, together with the specification, serve to explain the principles of the present disclosure. It is apparent that the drawings in the description below are only some embodiments of the present disclosure, and for those of ordinary skill in the art, other drawings can be obtained according to the drawings without creative efforts.
FIG. 1 illustrates a top perspective view of a substrate of a semiconductor structure according to an embodiment of the present disclosure;
FIG. 2 illustrates a cross-sectional view at a-a of the corresponding semiconductor structure in FIG. 1 according to an embodiment of the present disclosure;
FIG. 3 illustrates a cross-sectional view at c-c of the corresponding semiconductor structure in FIG. 1 according to an embodiment of the present disclosure;
FIG. 4 illustrates a schematic structural view of a semiconductor device according to an embodiment of the present disclosure;
FIG. 5 illustrates a flowchart of steps for a method for manufacturing a semiconductor structure according to an embodiment of the present disclosure;
FIGS. 6, 8, 10, 12, 14, and 16 sequentially illustrate cross-sectional views at a-a in the process of manufacturing the corresponding semiconductor structure in FIG. 1 according to an embodiment of the present disclosure; and
FIGS. 7, 9, 11, 13, 15, and 17 sequentially illustrate cross-sectional views at c-c in the process of manufacturing the corresponding semiconductor structure in FIG. 1 according to an embodiment of the present disclosure.

### DETAILED DESCRIPTION

To facilitate an understanding of the present disclosure, the present disclosure will be more fully described below with reference to the accompanying drawings. Preferred embodiments of the present disclosure are shown in the accompanying drawings. The present disclosure may, however, be implemented in many different forms and should not be construed as being limited to the embodiments described herein. Rather, these embodiments are provided so that the disclosed content of the present disclosure will be more thorough and complete.

The size of transistor cells integrated on a substrate of a semiconductor device is gradually reduced, such that a vertical channel transistor of a 4F² (F denotes a minimum feature size) architecture with a vertical channel is proposed. The area of the vertical channel transistor cell of the 4F² architecture can be reduced by about 30% as compared to a planar transistor of a 6F² architecture.

However, in an existing semiconductor structure with the vertical channel transistor, the contact resistance between an active pillar and a capacitor structure of the vertical channel transistor is high, which limits the transmission rate of the vertical channel transistor and affects the performance of the semiconductor structure.

In view of this, the embodiments of the present disclosure provide a semiconductor structure, a semiconductor device, and a method for manufacturing the semiconductor structure. In the semiconductor structure, capacitor contact structures are disposed between active pillars and capacitor structures, a line width effect during the formation of the capacitor contact structures is reduced, the contact area between the capacitor contact structures and the active pillars is increased, and the contact area between the capacitor structures and the capacitor contact structures is increased, such that the resistance between the capacitor structures and the active pillars is reduced, which improves the transmission rate of the vertical channel transistor, and further improves the performance of the semiconductor structure.

To make the objectives, technical solutions, and advantages of the embodiments of the present disclosure clearer, the technical solutions in the embodiments of the present disclosure will be clearly and completely described below with reference to the drawings in the embodiments of the present disclosure. It is evident that the described embodiments are some, but not all embodiments of the present disclosure. On the basis of the embodiments of the present disclosure, all other embodiments obtained by those of ordinary skill in the art without creative efforts shall fall within the protection scope of the present disclosure.

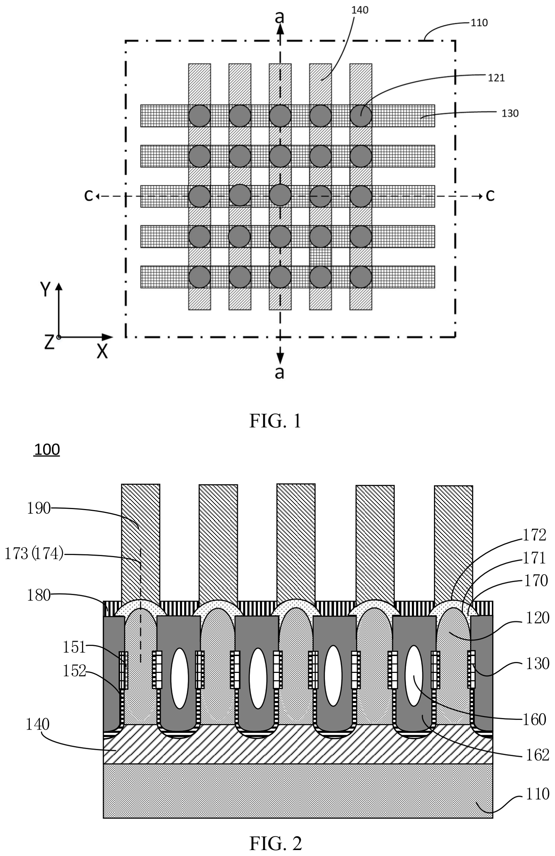

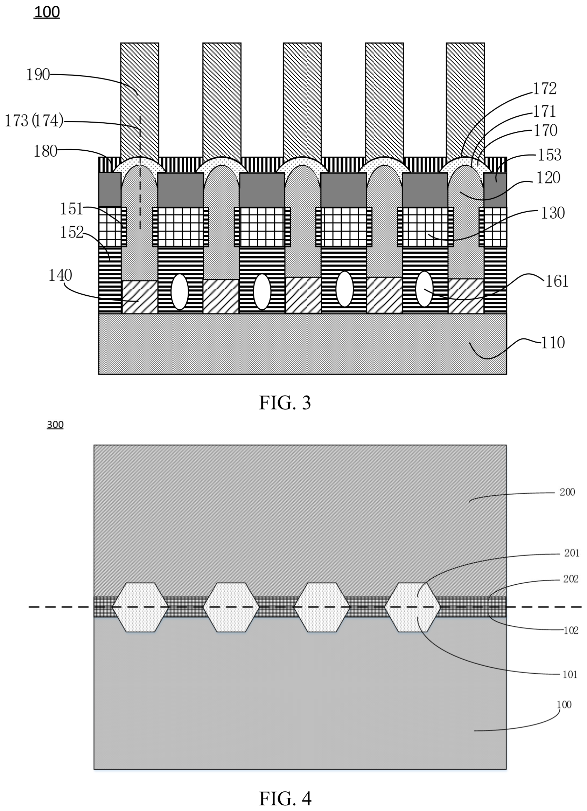

FIG. 1 is a top perspective view of a substrate of a semiconductor structure according to an embodiment of the present disclosure; FIG. 2 is a cross-sectional view at a-a of the corresponding semiconductor structure in FIG. 1; FIG. 3 is a cross-sectional view at c-c of the corresponding semiconductor structure in FIG. 1. Referring to FIG. 1, in one embodiment, a semiconductor structure 100 may include:
a substrate 110, where a plurality of active pillars 120 spaced apart from each other along a first direction and a second direction are formed in the substrate 110, the plurality of active pillars 120 extend along a third direction, the first direction intersects with the second direction, and both the first direction and the second direction are perpendicular to the third direction.

With further reference to FIG. 1, exemplarily, the first direction and the second direction may be perpendicular to each other, the first direction is, for example, the Y direction in FIG. 1, the second direction is, for example, the X direction in FIG. 1, and the third direction is, for example, the Z direction in FIG. 1, i.e., the thickness direction of the substrate 110. In other embodiments, the first direction and the second direction may not be perpendicular to each other. For example, an included angle between the first direction and the second direction may be an acute angle. The substrate 110 may be made of, for example, monocrystalline silicon, polycrystalline silicon, amorphous silicon, or silicon-on-insulator (SOI). In addition, the substrate 110 may be made of silicon germanium, silicon germanium-on-insulator (SGOI), indium antimonide, lead telluride compound, indium arsenide, indium phosphide, gallium arsenide, or gallium antimonide, but is not limited thereto. The plurality of active pillars 120 in the substrate 110 are spaced apart in an array and extend in the thickness direction of the substrate 110, i.e., the Z direction. The cross sections of the plurality of active pillars 120 may be circular, square, oval, or the like, so as to improve the integration of the semiconductor structure 100, without being limited thereto. The plurality of active pillars 120 are used for forming a channel region (not shown), a source region (not shown), and a drain region (not shown) of a vertical channel transistor.

Referring to FIG. 2, the semiconductor structure includes capacitor contact structures 170, where the capacitor contact structures 170 cover top surfaces of the plurality of active pillars 120 for connection to capacitor structures 190, and where top surfaces 172 of the capacitor contact structures 170 are non-planar, and projected areas of the capacitor contact structures 170 on planes perpendicular to the third direction are larger than projected areas of the plurality of active pillars 120 on planes perpendicular to the third direction. The capacitor contact structures 170 may be made of CoSi₂ or TiSi₂, which have superior thermal stability and conductivity compared to other metal silicides. Projected areas of lower electrodes (not shown) of the capacitor structures 190 on planes perpendicular to the third direction are smaller than the projected areas of the capacitor contact structures 170 on planes perpendicular to the third direction, i.e., the capacitor structures 190 may be completely seated on the capacitor contact structures 170. The top surfaces 172 of the capacitor contact structures 170 are non-planar, such that contact surfaces between the capacitor contact structures 170 and the capacitor structures 190 are as large as possible, which reduces the resistance between the capacitor contact structures 170 and the capacitor structures 190. A ratio of the projected areas of the capacitor contact structures 170 on planes perpendicular to the third direction to the projected areas of the plurality of active pillars 120 on planes perpendicular to the third direction is 1.2-2.0. The ratio cannot be too small, which would cause the lower electrodes of the capacitor structures 190 not to be completely seated on the capacitor contact structures 170, affecting the performance, such as the electrical performance, of the semiconductor structure 100, and the ratio cannot be too large, which would cause the capacitor contact structures 170 to connect to each other and thus cause a short circuit.

With further reference to FIG. 2, in one embodiment, the top surfaces 172 of the capacitor contact structures 170 are arc-shaped surfaces, which are easy to manufacture in a production process, such that the process difficulty and the manufacturing cost can be reduced. First contact surfaces 171 between the plurality of active pillars 120 and the capacitor contact structures 170 are arc-shaped surfaces protruding toward the capacitor contact structures. The plurality of active pillars 120 protrude toward the capacitor contact structures 170, such that the contact area between the plurality of active pillars 120 and the capacitor contact structures 170 is increased, and the resistance between the plurality of active pillars 120 and the capacitor contact structures 170 is reduced, thereby reducing the resistance between the plurality of active pillars 120 and the capacitor structures 190.

With further reference to FIG. 2, in one embodiment, center lines 173 of the plurality of active pillars 120 substantially overlap with center lines 174 of the capacitor contact structures 170. The center lines 173 of the plurality of active pillars 120 and the center lines 174 of the capacitor contact structures 170 may completely overlap or may substantially overlap, i.e., with process errors. That is, the center lines 173 of the plurality of active pillars 120 substantially overlap with the center lines 174 of the capacitor contact structures 170, so as to ensure that the capacitor structures 190 are seated right above the plurality of active pillars 120, thereby obtaining a vertical channel transistor of a 4F² (F denotes a minimum feature size) architecture. The area of the vertical channel transistor cell of the 4F² architecture can be reduced by about 30% as compared to a planar transistor of a 6F² architecture.

With further reference to FIG. 2, in one embodiment, first isolation structures 162 are formed between adjacent ones of the plurality of active pillars 120 along the first direction, i.e., the Y direction, and first voids 160 are present in the first isolation structures 162. Referring to FIG. 3, second isolation structures 152 are formed between adjacent ones of the plurality of active pillars 120 along the second direction, i.e., the X direction, top surfaces of the first isolation structures 162 are higher than top surfaces of the second isolation structures 152, and the first isolation structures may be made of silicon oxide, silicon nitride, silicon oxynitride, silicon oxycarbide, silicon carbonitride, a photoresist material, or a porous material. In this embodiment, the first isolation structures 162 are made of silicon nitride, and the silicon nitride is low-density silicon nitride, so as to reduce the stress of the first isolation structures 162 on the plurality of active pillars 120. The second isolation structures 152 may be one or more of silicon oxide, silicon nitride, silicon oxynitride, fluorosilicate glass (FSG), borosilicate glass (BSG), phosphosilicate glass (PSG), or borophosphosilicate glass (BPSG), and the first isolation structures 162 and the second isolation structures 152 are made of different materials. The first voids 160 in the first isolation structures 162 may improve the isolation effect of the first isolation structures 162, and enhance the insulation performance of the first isolation structures 162.

With further reference to FIG. 2, in one embodiment, at least portions of the first contact surfaces 171 between the plurality of active pillars 120 and the capacitor contact structures 170 are higher than the top surfaces of the first isolation structures 162, and the top surfaces 172 of the capacitor contact structures 170 are higher than the top surfaces of the first isolation structures 162, such that the influence of the line width effect can be reduced during the formation of the capacitor contact structures 170, and the resistance of the capacitor contact structures themselves can be reduced.

Referring to FIG. 2, in one embodiment, gate structures 130 are further formed in the substrate 110, the gate structures 130 surround portions of the plurality of active pillars 120, that is, the gate structures 130 surround channel regions of the plurality of active pillars 120. Referring to FIG. 1, adjacent ones of the gate structures 130 along the second direction, i.e., the X direction, are in contact connection to each other to form word lines, and adjacent ones of the gate structures 130 along the first direction, i.e., the Y direction, are insulated from each other. With further reference to FIG. 3, the gate structures 130 are located right above the second isolation structures 152, gate oxide layers 151 are further included between the gate structures 130 and the plurality of active pillars 120, and the gate oxide layers 151 may be of ring-shaped structures, that is, the gate oxide layers 151 surround the entire outer sidewalls of the channel regions of the plurality of active pillars 120. Alternatively, the gate oxide layers 151 may be of half ring-shaped structures, that is, the gate oxide layers 151 surround portions of the outer sidewalls of the channel regions of the plurality of active pillars 120, and other portions of the outer sidewalls of the channel regions may be exposed outside the gate oxide layers 151. The gate oxide layers 151 may be made of one or more of silicon oxide, fluorosilicate glass (FSG), borosilicate glass (BSG), phosphosilicate glass (PSG), or borophosphosilicate glass (BPSG). Third isolation structures 153 are formed between adjacent ones of the plurality of active pillars 120 along the second direction, i.e., the X direction, the third isolation structures 153 are located right above the gate structures 130, and the third isolation structures 153 may be made of silicon oxide, silicon nitride, silicon oxynitride, silicon oxycarbide, silicon carbonitride, a photoresist material, or a porous material. In this embodiment, the third isolation structures 153 and the first isolation structures 162 are made of the same material, i.e., silicon nitride. Referring to FIG. 1, bit line structures 140 are further formed in the substrate 110, the bit line structures 140 are located on a side of the substrate 110 away from an extension direction of the plurality of active pillars 120, the bit line structures 140 extend along the first direction, i.e., the Y direction, and adjacent ones of the bit line structures 140 along the second direction, i.e., the X direction, are insulated from each other. Referring to FIG. 3, the bit line structures 140 are electrically connected to the plurality of active pillars 120. Meanwhile, the bit line structures 140 are connected to first pads on the side of the substrate 110 away from the extension direction of the plurality of active pillars 120 through vias (not shown), so as to facilitate a subsequent bonding step. Second voids 161 are present in the second isolation structures 152 between the adjacent ones of the bit line structures 140, and the second voids 161 can improve the isolation performance of the second isolation structures 152 and prevent the bit line structures 140 from electric leakage.

Referring to FIG. 3, in one embodiment, the semiconductor structure 100 further includes: an insulating layer 180, where the insulating layer 180 covers the top surfaces of the first isolation structures 162, and both adjacent ones of the capacitor contact structures 170 along the first direction, i.e., the Y direction, and adjacent ones of the capacitor contact structures 170 along the second direction, i.e., the X direction, are isolated by the insulating layer 180. Meanwhile, the insulating layer 180 further covers top surfaces of the third isolation structures 153 and the top surfaces of the capacitor contact structures 170, such that in the subsequent process of manufacturing the capacitor structures 190, the insulating layer 180 can function as a supporting layer of the capacitor structures 190, thereby improving the stability of the capacitor structures 190. The insulating layer 180 may be made of one or more of silicon oxide, silicon nitride, silicon oxynitride, silicon oxycarbide, and silicon carbonitride. In this embodiment, the insulating layer 180 may be made of the same material as the third isolation structures 153 and/or the first isolation structures 162, so as to improve the adhesion between layers and avoid delamination in the subsequent steps which may affect the performance of the semiconductor structure 100.

With further reference to FIG. 2, the semiconductor structure further includes the capacitor structures 190 located on the capacitor contact structures 170, where second contact surfaces between the capacitor structures 190 and the capacitor contact structures 170 are arc-shaped surfaces, that is, the second contact surfaces between the capacitor structures 190 and the capacitor contact structures 170 are actually portions of the top surfaces 172 of the capacitor contact structures. In this way, the second contact surfaces between the capacitor structures 190 and the capacitor contact structures 170 are arc-shaped surfaces, such that the contact area between the capacitor structures 190 and the capacitor contact structures 170 is increased, and the resistance between the capacitor structures 190 and the capacitor contact structures 170 is reduced. Meanwhile, since the capacitor contact structures 170 have sufficiently large cross sections, the capacitor structures 190 can be completely seated on the capacitor contact structures 170, which avoids the problem that the third isolation structures 153 are damaged due to small capacitor contact structures 170 when the capacitor structures 190 are obtained by etching, such that the stability and the electrical performance of the capacitor structures 190 are improved.

On the basis of the above embodiments, an embodiment of the present disclosure further provides a semiconductor device. The semiconductor device will be described in detail below.

FIG. 4 illustrates a schematic structural view of a semiconductor device according to an embodiment of the present disclosure;
Referring to FIG. 4, in one embodiment, a semiconductor device 300 is obtained by bonding the above semiconductor structure 100 to a target wafer 200. The semiconductor device 300 may be a memory device or a non-memory device. The memory device may include, for example, a dynamic random access memory (DRAM), a static random access memory (SRAM), a flash memory, an electrically erasable programmable read-only memory (EEPROM), a phase change random access memory (PRAM), or a magnetoresistive random access memory (MRAM). The non-memory device may be a logic device (e.g., a microprocessor, a digital signal processor, or a microcontroller) or the like. The target wafer 200 includes CMOS transistors and the like. For example, the target wafer 200 includes peripheral transistors and the like in the semiconductor device 300, such as the DRAM. The bonding method of the semiconductor structure 100 and the target wafer 200 may be bump bonding, fusion bonding, hybrid bonding, etc., and the bonding method of the semiconductor structure 100 and the target wafer 200 may also be chip-to-chip bonding or wafer-on-wafer bonding.

In one embodiment, the semiconductor structure 100 and the target wafer 200 may be bonded through hybrid bonding. Referring to FIG. 4, the semiconductor structure 100 leads internal electrical signals to first pads 101 through vias (not shown), the target wafer 200 leads internal electrical signals to second pads 201 through vias (not shown), the first pads 101 are isolated by a first dielectric layer 102, and the second pads 201 are isolated by a second dielectric layer 202. The hybrid bonding between the semiconductor structure 100 and the target wafer 200 is achieved through an annealing process. The first pads 101 and the second pads 201 may be made of the same material, such as a metal, for example, copper, gold, or aluminum. The first dielectric layer 102 and the second dielectric layer 202 may be made of the same material, such as an insulating material, for example, silicon nitride Si₃N₄, silicon dioxide SiO₂, silicon carbonitride SiCN, silicon oxynitride SiON, hafnium oxide HfO, or zirconium oxide ZrO.

On the basis of the above embodiments, an embodiment of the present disclosure further provides a method for manufacturing a semiconductor structure (hereinafter referred to as the manufacturing method), which is used for manufacturing the above semiconductor structure 100. The manufacturing method is described in detail below.

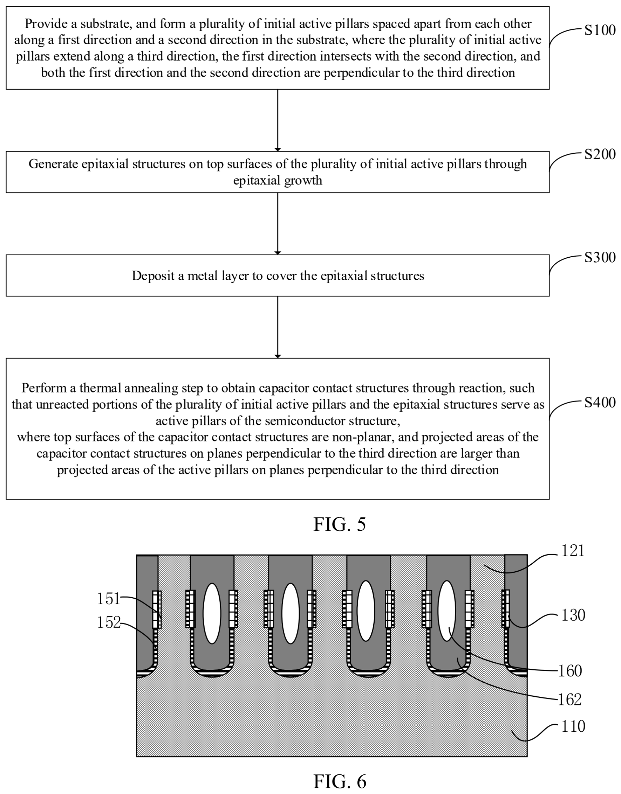

FIG. 5 is a flowchart of steps for a method for manufacturing a semiconductor structure according to an embodiment of the present disclosure; FIGS. 6, 8, 10, 12, 14, and 16 are cross-sectional views at a-a in the process of manufacturing the corresponding semiconductor structure in FIG. 1; FIGS. 7, 9, 11, 13, 15, and 17 are cross-sectional views at c-c in the process of manufacturing the corresponding semiconductor structure in FIG. 1. That is, FIGS. 6 and 7, FIGS. 8 and 9, FIGS. 10 and 11, FIGS. 12 and 13, FIGS. 14 and 15, and FIGS. 16 and 17 are cross-sectional views of the same structure from different perspectives, respectively.

Referring to FIG. 5, the method for manufacturing a semiconductor structure includes the following steps:
In S100, a substrate 110 is provided, and a plurality of initial active pillars 121 spaced apart from each other along a first direction and a second direction are formed in the substrate 110, where the plurality of initial active pillars 121 extend along a third direction, the first direction intersects with the second direction, and both the first direction and the second direction are perpendicular to the third direction. Exemplarily, the first direction and the second direction may be perpendicular to each other, the first direction is, for example, the Y direction in FIG. 1, the second direction is, for example, the X direction in FIG. 1, and the third direction is, for example, the Z direction in FIG. 1, i.e., the thickness direction of the substrate 110. In other embodiments, the first direction and the second direction may not be perpendicular to each other. For example, an included angle between the first direction and the second direction may be an acute angle.

Referring to FIG. 6, the substrate 110 may be made of, for example, monocrystalline silicon, polycrystalline silicon, amorphous silicon, or silicon-on-insulator (SOI). In addition, the substrate 110 may be made of silicon germanium, silicon germanium-on-insulator (SGOI), indium antimonide, lead telluride compound, indium arsenide, indium phosphide, gallium arsenide, or gallium antimonide, but is not limited thereto. The plurality of initial active pillars 121 in the substrate 110 are spaced apart in an array and extend in the thickness direction of the substrate 110, i.e., the Z direction. The cross sections of the plurality of initial active pillars 121 may be circular, square, or oval, so as to improve the integration of the semiconductor structure 100, without being limited thereto.

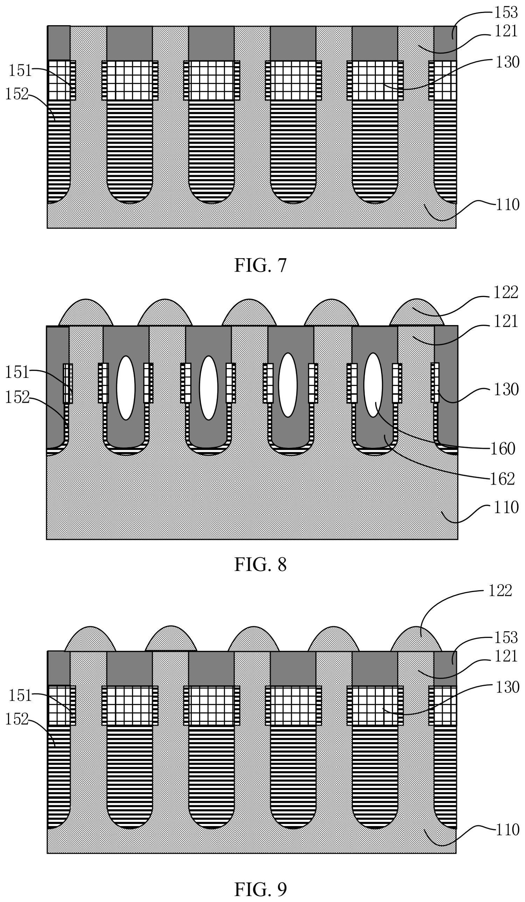

With further reference to FIG. 6, in one embodiment, first isolation structures 162 are formed between adjacent ones of the plurality of initial active pillars 121 along the first direction, i.e., the Y direction, and first voids 160 are present in the first isolation structures 162. Referring to FIG. 7, second isolation structures 152 are formed between adjacent ones of the plurality of initial active pillars 121 along the second direction, i.e., the X direction, top surfaces of the first isolation structures 162 are higher than top surfaces of the second isolation structures 152, and the first isolation structures may be made of silicon oxide, silicon nitride, silicon oxynitride, silicon oxycarbide, silicon carbonitride, a photoresist material, or a porous material. In this embodiment, the first isolation structures 162 are made of silicon nitride, and the silicon nitride is low-density silicon nitride, so as to reduce the stress of the first isolation structures 162 on the plurality of initial active pillars 121. The second isolation structures 152 may be one or more of silicon oxide, silicon nitride, silicon oxynitride, fluorosilicate glass (FSG), borosilicate glass (BSG), phosphosilicate glass (PSG), or borophosphosilicate glass (BPSG), and the first isolation structures 162 and the second isolation structures 152 are made of different materials. The first voids 160 in the first isolation structures 162 may improve the isolation effect of the first isolation structures 162, and enhance the insulation performance of the first isolation structures 162.

With further reference to FIG. 6, in one embodiment, gate structures 130 are further formed in the substrate 110, the gate structures 130 surround portions of the plurality of initial active pillars 121, adjacent ones of the gate structures 130 along the second direction, i.e., the X direction, are in contact connection to each other to form word lines, and adjacent ones of the gate structures 130 along the first direction, i.e., the Y direction, are insulated from each other. With further reference to FIG. 7, the gate structures 130 are located right above the second isolation structures 152, gate oxide layers 151 are further included between the gate structures 130 and the plurality of initial active pillars 121, and the gate oxide layers 151 may be of ring-shaped structures. The gate oxide layers 151 may be made of one or more of silicon oxide, fluorosilicate glass (FSG), borosilicate glass (BSG), phosphosilicate glass (PSG), or borophosphosilicate glass (BPSG). Third isolation structures 153 are formed between adjacent ones of the plurality of initial active pillars 121 along the second direction, i.e., the X direction, the third isolation structures 153 are located right above the gate structures 130, and the third isolation structures 153 may be made of silicon oxide, silicon nitride, silicon oxynitride, silicon oxycarbide, silicon carbonitride, a photoresist material, or a porous material. In this embodiment, the third isolation structures 153 and the first isolation structures 162 are made of the same material, i.e., silicon nitride.

In S200, epitaxial structures 122 are generated on top surfaces of the plurality of initial active pillars 121 through epitaxial growth.

Referring to FIGS. 8-9, the epitaxial structures 122 are generated on the top surfaces of the plurality of initial active pillars 121, and the epitaxial structures 122 may be monocrystalline silicon, which are specifically manufactured by introducing silane and hydrogen chloride gas at a certain temperature, such as higher than 500 degrees Celsius, and a certain pressure, such as lower than 10 Torr, by using an epitaxial apparatus, such that the epitaxial structures 122 are gradually generated on the top surfaces of the plurality of initial active pillars 121, where the epitaxial structures are in a mushroom head shape.

With further reference to FIG. 8, in one embodiment, top surfaces of the epitaxial structures 122 are non-planar, and projected areas of the epitaxial structures 122 on planes perpendicular to the third direction are larger than projected areas of the plurality of initial active pillars 121 on planes perpendicular to the third direction, which is beneficial to the electrical performance of the resulting capacitor contact structures 170 from subsequent reactions.

With further reference to FIG. 8, in one embodiment, the top surfaces of the epitaxial structures 122 are arc-shaped surfaces, and bottom surfaces of the epitaxial structures 122 are flush with top surfaces of the first isolation structures 162.

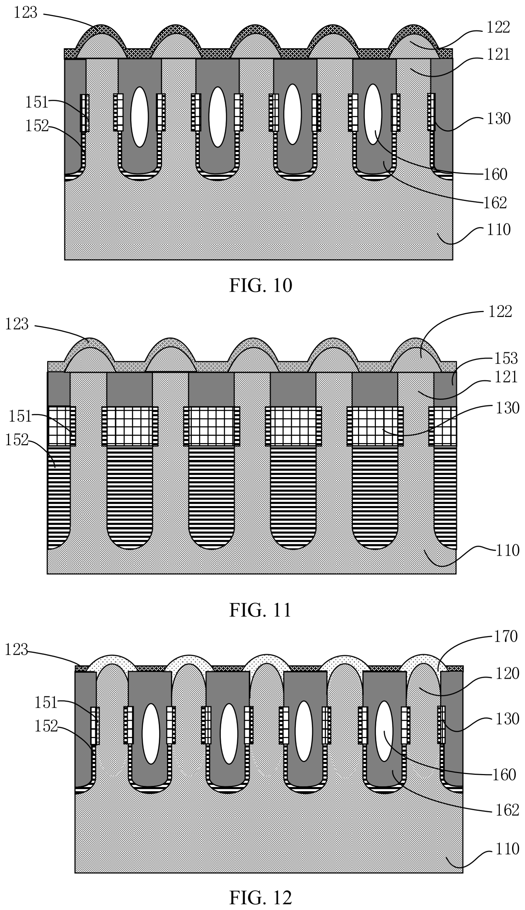

In S300, a metal layer 123 is deposited to cover the epitaxial structures 122. Referring to FIGS. 10-11, the metal layer 123 is deposited over the epitaxial structures 122, and the metal layer 123 may be made of Co or Ti, of which the silicides have excellent thermal stability.

Compared to the prior art where the first isolation structures 162 are etched back and then the metal layer 123 is deposited, in the present disclosure, the epitaxial structures 122 are first generated on the top surfaces of the plurality of initial active pillars 121 through epitaxial growth, thereby avoiding the damage to the first voids 160 caused by etching back the first isolation structures 162 in the prior art, and further avoiding the deposition of impurities in the first voids 160 in the subsequent steps, such that the performance stability of the semiconductor structure 100 is improved.

In S400, a thermal annealing step is performed to obtain capacitor contact structures 170 through reaction, such that unreacted portions of the plurality of initial active pillars 121 and the epitaxial structures 122 serve as active pillars 120 of the semiconductor structure, where top surfaces of the capacitor contact structures 170 are non-planar, and projected areas of the capacitor contact structures 170 on planes perpendicular to the third direction are larger than projected areas of the active pillars 120 on planes perpendicular to the third direction.

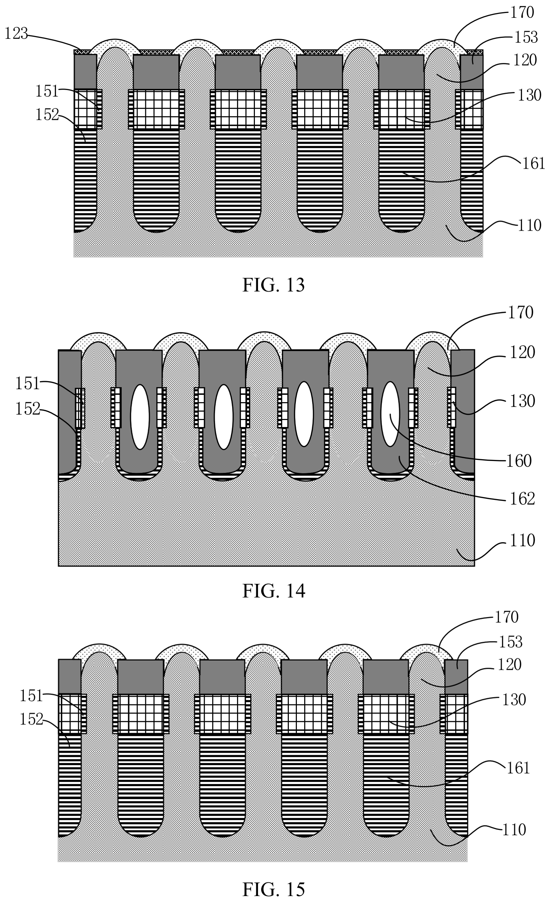

Referring to FIGS. 14-15, the thermal annealing step is performed, such that the metal layer 123 reacts with the epitaxial structures 122 and the plurality of initial active pillars 121 at a first temperature to obtain the capacitor contact structures 170. The above thermal annealing step is a first annealing step. For example, the metal layer 123 is made of Co or Ti, the epitaxial structures 122 and the plurality of initial active pillars 121 are both made of monocrystalline silicon, such that the two react to obtain the capacitor contact structures 170, which may be made of CoSi₂ or TiSi₂ with excellent thermal stability and conductivity. The unreacted portions of the plurality of initial active pillars 121 and the epitaxial structures 122 serve as the active pillars 120 of the semiconductor structure 100. In the prior art, silicon that reacts with the metal layer is sandwiched between the first isolation structures, and the silicon sandwiched between the first isolation structures in the thermal annealing step may have a severe line width effect, and the resistance of the obtained metal silicide is high, whereas the metal layer 123 in the present disclosure mainly reacts with the epitaxial structures 122, and the epitaxial structures 122 are not sandwiched between the first isolation structures 162, such that the line width effect is largely avoided, and the resistance of the obtained metal silicide is reduced.

With further reference to FIG. 14, the top surfaces 172 of the capacitor contact structures 170 are non-planar, such that contact surfaces between the capacitor contact structures 170 and the capacitor structures 190 are as large as possible, which reduces the resistance between the capacitor contact structures 170 and the capacitor structures 190. The projected areas of the capacitor contact structures 170 on planes perpendicular to the third direction are larger than the projected areas of the active pillars 120 on planes perpendicular to the third direction. A ratio of the projected areas of the capacitor contact structures 170 on planes perpendicular to the third direction to the projected areas of the active pillars 120 on planes perpendicular to the third direction is 1.2-2.0. The ratio cannot be too small, which would cause the lower electrodes of the capacitor structures 190 not to be completely seated on the capacitor contact structures 170, and the ratio cannot be too large, which would cause the capacitor contact structures 170 to connect to each other and thus cause a short circuit.

With further reference to FIG. 14, in one embodiment, the top surfaces 172 of the capacitor contact structures 170 are arc-shaped surfaces, which are easy to manufacture in a production process, such that the process difficulty and the manufacturing cost can be reduced. First contact surfaces 171 between the active pillars 120 and the capacitor contact structures 170 are arc-shaped surfaces protruding toward the capacitor contact structures. The active pillars 120 protrude toward the capacitor contact structures 170, such that the contact area between the active pillars 120 and the capacitor contact structures 170 is increased, and the resistance between the active pillars 120 and the capacitor contact structures 170 is reduced.

With further reference to FIG. 14, in one embodiment, at least portions of the first contact surfaces 171 between the active pillars 120 and the capacitor contact structures 170 are higher than the top surfaces of the first isolation structures 162, which is a necessary consequence of the manufacturing method of the present disclosure.

In one embodiment, the method for manufacturing the semiconductor structure 100 includes: removing unreacted portions of the metal layer 123 after the thermal annealing step is performed.

Referring to FIGS. 12-13, the unreacted portions of the metal layer 123 are removed by acid pickling, such as using sulfuric acid, so as to prevent the capacitor contact structures 170 from being in contact with each other, thereby preventing the short circuit of the capacitor contact structures 170.

In one embodiment, the method for manufacturing the semiconductor structure 100 includes: performing a second thermal annealing step after the unreacted portions of the metal layer 123 are removed. That is, the second thermal annealing step is performed at a second temperature, which is greater than the first temperature of the first thermal annealing step, such that the resistance of the capacitor contact structures 170 may be further reduced by two thermal annealing steps.

In one embodiment, the method for manufacturing the semiconductor structure further includes: depositing an insulating layer 180 to manufacture the capacitor structures 190.

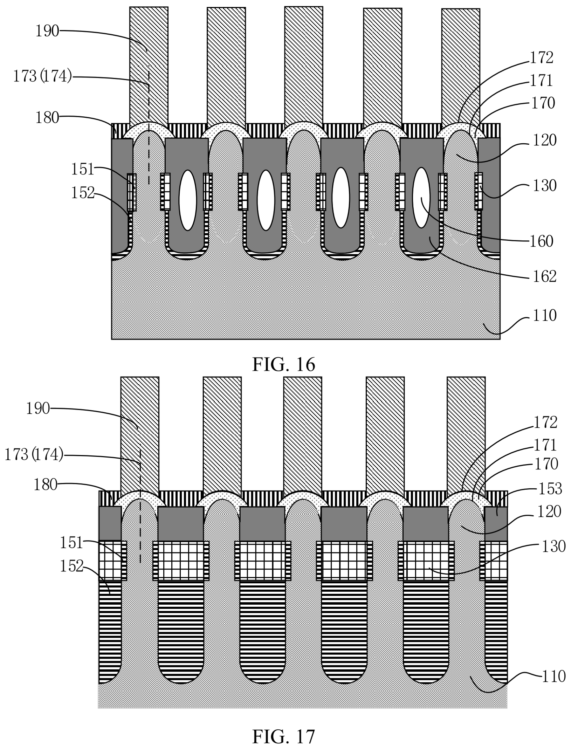

Referring to FIG. 16, the insulating layer 180 covers the top surfaces of the first isolation structures 162, and both adjacent ones of the capacitor contact structures 170 along the first direction, i.e., the Y direction, and adjacent ones of the capacitor contact structures 170 along the second direction, i.e., the X direction, are isolated by the insulating layer 180. Meanwhile, referring to FIG. 17, the insulating layer 180 further covers top surfaces of the third isolation structures 153 and the top surfaces of the capacitor contact structures 170, such that in the subsequent process of manufacturing the capacitor structures 190, the insulating layer 180 can function as a supporting layer of the capacitor structures 190, thereby improving the stability of the capacitor structures 190. The insulating layer 180 may be made of one or more of silicon oxide, silicon nitride, silicon oxynitride, silicon oxycarbide, and silicon carbonitride. In this embodiment, the insulating layer 180 may be made of the same material as the third isolation structures 153 and/or the first isolation structures 162, so as to improve the adhesion between layers and avoid delamination in the subsequent steps which may affect the performance of the semiconductor structure 100.

Referring to FIG. 16, the capacitor structures 190 are manufactured on the capacitor contact structures 170, where second contact surfaces between the capacitor structures 190 and the capacitor contact structures 170 are arc-shaped surfaces, that is, the second contact surfaces between the capacitor structures 190 and the capacitor contact structures 170 are actually portions of the top surfaces 172 of the capacitor contact structures. In this way, the second contact surfaces between the capacitor structures 190 and the capacitor contact structures 170 are arc-shaped surfaces, such that the contact area between the capacitor structures 190 and the capacitor contact structures 170 is increased, and the resistance between the capacitor structures 190 and the capacitor contact structures 170 is reduced. Meanwhile, since the capacitor contact structures 170 have sufficiently large cross sections, the capacitor structures 190 can be completely seated on the capacitor contact structures 170, which avoids the problem that the third isolation structures 153 are damaged due to small capacitor contact structures 170 when the capacitor structures 190 are etched, such that the stability and the electrical performance of the capacitor structures 190 are improved.

In one embodiment, the method for manufacturing the semiconductor structure further includes: manufacturing bit line structures 140, and manufacturing second voids 161.

Referring to FIGS. 2-3, the active pillars 120 are exposed by thinning the substrate 110, the bit line structures 140 are deposited, the bit line structures 140 extend along the first direction, i.e., the Y direction, and adjacent ones of the bit line structures 140 along the second direction, i.e., the X direction, are insulated from each other. The bit line structures 140 are electrically connected to the active pillars 120, and further, vias (not shown) and first pads on a side of the substrate 110 away from an extension direction of the active pillars 120 are formed, and electrical signals are led out onto the first pads through the vias (not shown), so as to facilitate a subsequent bonding step. In addition, second voids 161 are formed in the second isolation structures 152 between the adjacent ones of the bit line structures 140, and the second voids 161 can improve the isolation performance of the second isolation structures 152 and prevent the bit line structures 140 from electric leakage. Through the above method for manufacturing the semiconductor structure, the existing process is simplified, the line width effect during the formation of the capacitor contact structures can be reduced, the generation of metal residue defects is avoided, i.e., the damage of the first voids is avoided, the contact area between the capacitor contact structures and the active pillars is increased, the contact area between the capacitor structures and the capacitor contact structures is increased, such that the resistance between the capacitor structures and the active pillars is reduced, which improves the transmission rate of the vertical channel transistor, and further improves the performance of the semiconductor structure.

In the description of the present disclosure, it should be understood that the terms "center", "longitudinal", "transverse", "length", "width", "thickness", "upper", "lower", "front", "rear", "left", "right", "vertical", "horizontal", "top", "bottom", "inner", "outer", and the like indicate directional or positional relationships based on those shown in the drawings, merely for convenience of description of the present disclosure, and do not indicate or imply that the equipment or element referred to must have a particular direction, or be constructed and operated in a particular direction, and thus, are not to be construed as limiting the present disclosure.

In the description of the present disclosure, it should be understood that the terms "include" and "have" and any variations thereof, as used herein, are intended to cover non-exclusive inclusion. For example, a process, method, system, product, or apparatus including a series of steps or units is not necessarily limited to the explicitly listed steps or units, but may include other steps or units that are not explicitly listed or are inherent to such process, method, product, or apparatus.

Unless expressly stated or limited otherwise, the terms "mount", "connect", "link", "fix", and the like are to be construed in a broad sense. For example, it may be a fixed connection, a detachable connection, or integration; or may be a direct connection, an indirect connection by means of an intermediate, and an internal interconnection of two elements or an interaction of two elements. For those of ordinary skill in the art, the specific meaning of the above terms in the present disclosure may be understood according to the specific condition. In addition, the terms "first", "second", and the like, are only for the purpose of description, and may not be construed as indicating or implying the relative importance or implicitly indicating the number of technical features indicated.

Finally, it should be noted that: the above embodiments are merely used for illustrating the technical solutions of the present disclosure, rather than being limited; although the present disclosure has been described in detail with reference to the above embodiments, those of ordinary skill in the art will appreciate that: the technical solutions described in the foregoing embodiments may still be modified, or some or all of the technical features may be equivalently replaced; these modifications or replacements do not cause the essence of the corresponding technical solutions to depart from the scope of the technical solutions of the embodiments of the present disclosure.

## Claims

1. A semiconductor structure (100),
comprising:
a substrate (110), wherein a plurality of active pillars (120) spaced apart from each other along a first direction and a second direction are formed in the substrate (110), the plurality of active pillars (120) extend along a third direction, the first direction intersects with the second direction, and both the first direction and the second direction are perpendicular to the third direction; and
capacitor contact structures (170), wherein the capacitor contact structures (170) cover top surfaces of the plurality of active pillars (120) for connection to capacitor structures (190), and
wherein top surfaces of the capacitor contact structures (170) are non-planar, and projected areas of the capacitor contact structures (170) on planes perpendicular to the third direction are larger than projected areas of the plurality of active pillars (120) on planes perpendicular to the third direction.

2. The semiconductor structure according to claim 1, wherein the top surfaces of the capacitor contact structures (170) are arc-shaped surfaces, and first contact surfaces (171) between the plurality of active pillars (120) and the capacitor contact structures (170) are arc-shaped surfaces protruding toward the capacitor contact structures (170).

3. The semiconductor structure according to claim 1, wherein center lines (173) of the plurality of active pillars (120) substantially overlap with center lines (174) of the capacitor contact structures (170).

4. The semiconductor structure according to claim 1, wherein first isolation structures (162) are formed between adjacent ones of the plurality of active pillars (120) along the first direction, and first voids (160) are present in the first isolation structures (162).

5. The semiconductor structure according to claim 4, wherein at least portions of the first contact surfaces (171) between the plurality of active pillars (120) and the capacitor contact structures (170) are higher than top surfaces of the first isolation structures (162).

6. The semiconductor structure according to claim 1, wherein gate structures (130) are further formed in the substrate (110), the gate structures (130) surround portions of the plurality of active pillars (120), adjacent ones of the gate structures (130) along the second direction are in contact connection to each other, adjacent ones of the gate structures (130) along the first direction are insulated from each other; and bit line structures (140) are further formed in the substrate (110), the bit line structures (140) are located on a side of the substrate (110) away from an extension direction of the plurality of active pillars (120), the bit line structures (140) extend along the first direction, and adjacent ones of the bit line structures (140) along the second direction are insulated from each other.

7. The semiconductor structure according to claim 4, further comprising:
an insulating layer (180), wherein the insulating layer (180) covers the top surfaces of the first isolation structures (162), and both adjacent ones of the capacitor contact structures (170) along the first direction and adjacent ones of the capacitor contact structures (170) along the second direction are isolated by the insulating layer (180); and
the capacitor structures (190) located on the capacitor contact structures (170), wherein second contact surfaces between the capacitor structures (190) and the capacitor contact structures (170) are arc-shaped surfaces.

8. A semiconductor device (300), obtained by bonding the semiconductor structure (100) according to any one of claims 1 to 7 to a target wafer (200).

9. A method for manufacturing a semiconductor structure, comprising:
providing a substrate (110), and forming a plurality of initial active pillars (121) spaced apart from each other along a first direction and a second direction in the substrate (110), wherein the plurality of initial active pillars (121) extend along a third direction, the first direction intersects with the second direction, and both the first direction and the second direction are perpendicular to the third direction;
generating epitaxial structures (122) on top surfaces of the plurality of initial active pillars (121) through epitaxial growth;
depositing a metal layer (123) to cover the epitaxial structures (122); and
performing a thermal annealing step to obtain capacitor contact structures (170) through reaction, such that unreacted portions of the plurality of initial active pillars (121) and the epitaxial structures (122) serve as active pillars (120) of the semiconductor structure,
wherein top surfaces of the capacitor contact structures (170) are non-planar, and projected areas of the capacitor contact structures (170) on planes perpendicular to the third direction are larger than projected areas of the active pillars (120) on planes perpendicular to the third direction.

10. The manufacturing method according to claim 9, wherein top surfaces of the epitaxial structures (122) are non-planar, and projected areas of the epitaxial structures (122) on planes perpendicular to the third direction are larger than projected areas of the plurality of initial active pillars (121) on planes perpendicular to the third direction.

11. The manufacturing method according to claim 10, wherein the top surfaces of the capacitor contact structures (170) and the top surfaces of the epitaxial structures (122) are arc-shaped surfaces, and first contact surfaces (171) between the active pillars (120) and the capacitor contact structures (170) are arc-shaped surfaces protruding toward the capacitor contact structures (170).

12. The manufacturing method according to claim 9, further comprising: forming first isolation structures (162) between adjacent ones of the active pillars (120) along the first direction and forming first voids (160) in the first isolation structures (162).

13. The manufacturing method according to claim 12, wherein bottom surfaces of the epitaxial structures (122) are flush with top surfaces of the first isolation structures (162), and at least portions of first contact surfaces (171) between the active pillars (120) and the capacitor contact structures (170) are higher than the top surfaces of the first isolation structures (162).

14. The manufacturing method according to claim 9, further comprising: removing unreacted portions of the metal layer (123) after the thermal annealing step is performed.

15. The manufacturing method according to claim 9, wherein the metal layer (123) is made of Co or Ti, and the epitaxial structures (122) are made of monocrystalline silicon.
